Europäisches Patentamt

European Patent Office

Office européen des brevets

(11) Veröffentlichungsnummer: **0 552 404 A1**

## (12) EUROPÄISCHE PATENTANMELDUNG

(21) Anmeldenummer: **92112606.6**

(22) Anmeldetag: **23.07.92**

(51) Int. Cl.5: **G11C 5/14**, G11C 11/407

(43) Veröffentlichungstag der Anmeldung:
**28.07.93 Patentblatt 93/30**

(84) Benannte Vertragsstaaten:
**AT BE CH DE DK ES FR GB GR IT LI LU MC NL PT SE**

(71) Anmelder: **SIEMENS AKTIENGESELLSCHAFT**
**Wittelsbacherplatz 2**
**W-8000 München 2(DE)**

(72) Erfinder: **Strunz, Roland, Dipl.-Ing.**
**Putzbrunnerstrasse 18**
**W-8000 München 83(DE)**
Erfinder: **Pribyl, Wolfgang, Dr. Dipl.-Ing.**
**Kaltenbrunngasse 1**
**W-8043 Graz(DE)**

(54) **Schaltungsanordnung zur Begrenzung der Ausgangsspannung einer Spannungserhöhungsschaltung.**

(57) Eine übliche Spannungserhöhungsschaltung für DRAMS wird um eine Schutzschaltung erweitert, die unzulässig hohe Spannungen verhindert. Dies wird erreicht, indem die sogenannten Schiebekapazitäten aufgeteilt werden und je nach Höhe der Versorgungsspannung unterschiedlich viele Schiebekapazitäten zur Spannungserhöhung mittels einer Ansteuerlogik angesteuert werden.

FIG 1

EP 0 552 404 A1

Die Erfindung eine Schaltungsanordnung zur Begrenzung der Ausgangsspannung bei einer Spannungserhöhungsschaltung gemäß dem Oberbegriff des Anspruchs 1.

Um die Fehlerrate beim dynamischen Speichern zu verringern, werden intern zum Lesen und Schreiben derartiger dynamischer Speicher höhere Spannungen verwendet als die zur Verfügung stehende 5V-Versorgungsspannung. Da Mikrocomputersysteme mit derartigen dynamischen Speichern meist nur eine Versorgungsspannung aufweisen, muß eine Spannungserhöhungsschaltung innerhalb der dynamischen RAM-Bausteine für eine erhöhte Spannung zum Schreiben und Lesen derartiger Speicher sorgen.

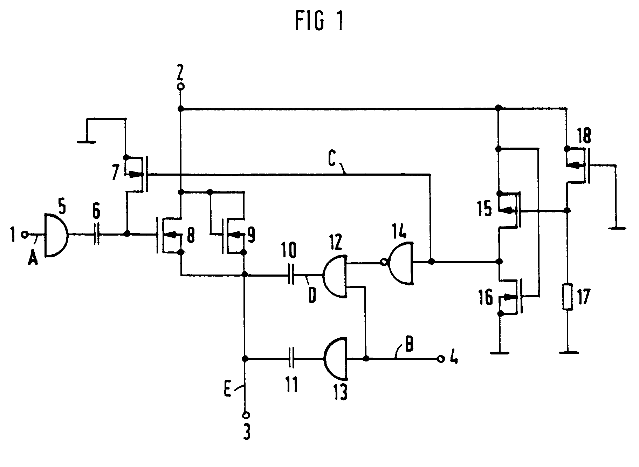

Aus Mitsubishi Semiconductors IC memories 1987, Seite 10-5, FIG 1.6 ist eine derartige Spannungserhöhungsschaltung bekannt. Diese Schaltungsanordnung gewährt in Abhängigkeit der Kapazität C2 eine Erhöhung der Versorgungsspannung $V_{CC}$ um einen entsprechenden Spannungswert.

Schwankt die Versorgungsspannung $V_{CC}$ eines derartig ausgebildeten dynamischen Speichers, so schwankt auch die zum Lesen und Schreiben benötigte erhöhte Spannung. Überschreitet eine derart erhöhte Spannung z. B. 16 V, so kommt es bei n-Kanal-Transistoren zu Durchbrüchen der p/n-Übergänge ins Substrat. Dieser Prozeß kann zu einer Zerstörung des p/n-Übergangs führen. Übersteigt die Versorgungsspannung $V_{CC}$ z. B. 6 V, so sind alle derartigen Knoten, die mit einer erhöhten Spannung betrieben werden, gefährdet.

Aufgabe der Erfindung ist es, eine Schaltungsanordnung zur Begrenzung der Ausgangsspannung bei einer Spannungserhöhungsschaltung anzugeben, die dafür sorgt, daß bei unterschiedlichen Versorgungsspannungen, die durch die Spannungserhöhungsschaltung erzeugte Schreib/Lesespannung innerhalb eines zulässigen Bereichs bleibt.

Diese Aufgabe wird durch den kennzeichnenden Teil des Anspruchs 1 gelöst. Weiterbildungen sind Kennzeichen der Unteransprüche.

Ein erfindungswesentlicherer Vorteil ist, daß anstelle einer Kapazität C2 aus FIG 1.6 der obengenannten Schrift mehrere Kapazitäten verwendet werden. Diese Kapazitäten sind einseitig mit dem Knoten verbunden, der mit der erhöhten Betriebsspannung beaufschlagt werden soll. Eine erfindungsgemäße Ansteuerschaltung schaltet entsprechend der Höhe der Versorgungsspannung mehr oder weniger Kapazitäten parallel. Werden z. B. zwei anstelle der einen Kapazität verwendet, so können bei niedriger Versorgungsspannung beide Kapazitäten parallel geschaltet werden. Überschreitet die Versorgungsspannung eine bestimmte Schwelle, so wird die zusätzliche Kapazität von der Ansteuerschaltung abgetrennt. Dadurch werden unterschiedliche Spannungsverschiebungen gewährt, da die Höhe der Verschiebung abhängig von der Lastkapazität, d. h. derjenigen Kapazität des Knotens mit der erhöhten Spannung und der Schiebekapazität, d. h. derjenigen Kapazität der wirksamen Schiebekondensatoren, ist.

Die Erfindung wird nachfolgend anhand von drei Figuren näher erläutert. Es zeigen:

FIG 1    ein Ausführungsbeispiel für die erfindungsgemäße Schaltungsanordnung

FIG 2    einen zeitlichen Verlauf verschiedener Signale aus der in FIG 1 dargestellten Schaltung bei einer ersten Versorgungsspannung

FIG 3    den zeitlichen Verlauf verschiedener Signale aus der in FIG 1 dargestellten Schaltung bei einer zweiten Versorgungsspannung.

In FIG 1 ist mit 1 eine Eingangsklemme bezeichnet, an der ein Vorladesteuersignal anlegbar ist. Diese Eingangsklemme ist über eine Treiberstufe 5 mit dem ersten Anschluß eines Kondensators 6 verbunden. Der zweite Anschluß des Kondensators 6 ist mit dem Drainanschluß eines FETs 7 und dem Gateanschluß eines FETs 8 verbunden. Der Sourceanschluß des FETs 7 ist mit Masse verschaltet. Eine weitere Eingangsklemme 2 ist vorgesehen, an der die Versorgungsspannung $V_{CC}$ anlegbar ist. Diese Eingangsspannungsklemme 2 ist mit dem Drainanschluß des FETs 8 und mit dem Drainanschluß sowie Gateanschluß des FETs 9 verbunden. Die Sourceanschlüsse der FETs 8 und 9 sind ebenfalls miteinander verschaltet und führen zu einer Anschlußklemme 3, an der die erhöhte Ausgangsspannung abgegriffen werden kann. Die Ausgangsklemme 3 ist weiterhin jeweils mit dem ersten Anschluß eines Kondensators 10 und eines Kondensators 11 verbunden. Der zweite Anschluß des Kondensators 10 ist mit dem Ausgang eines UND-Gatters 12 verschaltet. Der zweite Anschluß des Kondensators 11 ist mit dem Ausgang einer Treiberstufe 13 verbunden. Der erste Eingang des UND-Gatters 12 ist mit dem Ausgang eines Inverters 14 verschaltet. Der zweite Eingang des UND-Gatters 12 ist mit dem Eingang der Treiberstufe 13 kurzgeschlossen. Weiterhin ist der Eingang der Treiberstufe 13 mit einer Anschlußklemme 4 verbunden, an der das Spannungserhöhungssteuersignal zuführbar ist. Der Eingang des Inverters 14 ist mit dem Gateanschluß des FETs 7 verbunden. Weiterhin ist die Versorgungsspannungsklemme 2 jeweils mit dem Sourceanschluß eines FETs 15 und eines FETs 18 verbunden. Der Gateanschluß des FETs 15 ist mit dem Drainanschluß des FETs 18 verschaltet. Der Drainanschluß des FETs 15 ist mit dem Eingang des Inverters 14 und mit dem Drainanschluß des n-Kanal-FETs 16 verbunden. Der Drainanschluß des FETs 18 ist weiterhin über einen Widerstand 17 mit Masse verschaltet. Der Sourceanschluß des FETs 16 und der Gateanschluß des FETs 18 sind ebenfalls mit Masse verbunden. Schließlich ist der Gateanschluß des FETs 16 mit der Versorgungsspannungsklemme 2 verschaltet. Mit A bis E sind verschiedene Knotenpunkte der Schaltungsanordnung bezeichnet.

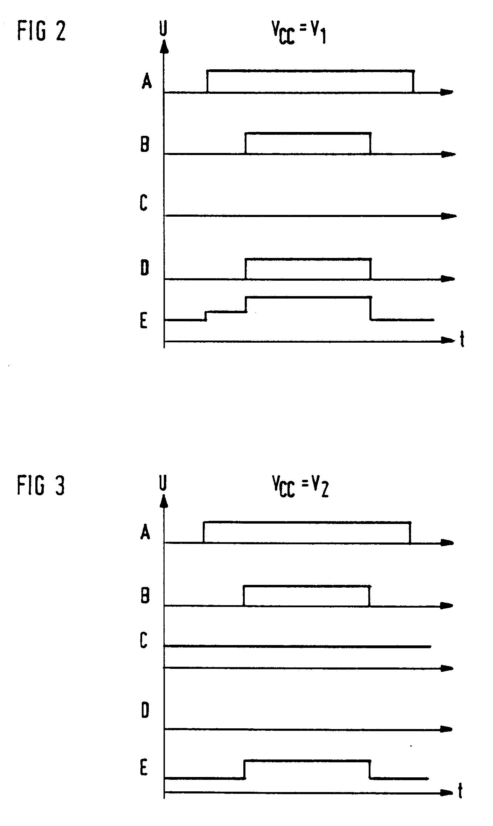

Die Figuren 2 und 3 zeigen den zeitlichen Spannungsverlauf von Signalen an verschiedenen Punkten A bis E der Schaltung aus FIG 1. FIG 2 zeigt den zeitlichen Verlauf für eine Betriebsspannung $V_{CC}$ = V1, wobei V1 eine Spannung unterhalb eines vorgegebenen Schwellwerts sein soll.

FIG 3 zeigt den zeitlichen Verlauf an den gleichen Punkten für eine Betriebsspannung $V_{CC}$ = V2, wobei V2 eine Versorgungsspannung oberhalb des Schwellwerts sein soll.

Die zeitliche Darstellung der Signalverläufe, insbesondere die Dauer der einzelnen Signale zueinander ist hier nur schematisch dargestellt. Die dargestellten Spannungswerte der einzelnen Signale in den FIG 2 und 3 sind ebenso unterschiedlich.

Der Spannungskomparator besteht aus den FETs 15, 16, 18 und dem Widerstand 17. Das Verhältnis zwischen Kanalweite und Kanallänge der FETs 16 und 18 ist derart ausgelegt, daß am Ausgang des Spannungskomparators ein logisches Nullsignal anliegt, sobald die Versorgungsspannung unterhalb von 6 V liegt und ein logisches Einssignal bei einer Versorgungsspannung größer 6 V erzeugt wird. Dies kann z. B. dadurch erreicht werden, daß das Kanalweiten zu -längenverhältnis ungefähr gleich 1 : 100 ist.

Liegt an der Versorgungsspannungsklemme eine Betriebsspannung $V_{CC}$ = V1 an, deren Wert unterhalb der Schwelle liegt, die z. B. 6 V beträgt, so wird am Ausgang des Spannungskomparators ein logisches Nullsignal erzeugt. Dieses ist in FIG 2 in der Teilfigur C dargestellt. In der Pause, d. h. während der Zeit, an der an den Eingangsklemmen 1 und 4 ein logisches Nullsignal anliegt, wird der Knoten, welcher in FIG 1 mit E bezeichnet ist, sicher auf die Versorgungsspannung $V_{CC}$ abzüglich der Durchlaßspannung des als Diode geschalteten Transistors 9 aufgeladen. Zu Beginn eines Zyklusses der in FIG 2 in Teilfigur A mit der steigenden Flanke dargestellt ist, wird der Transistor 8 leitend geschaltet, da der Transistor 7 im sperrenden Zustand ist. Auf diese Weise wird die Spannung am Knoten E nochmals ein wenig erhöht, da der Übergangswiderstand zwischen Versorgungsspannungsklemme 2 und Knoten E durch diesen Transistor 8 minimiert wird. Diese Spannungserhöhung ist in Teilfigur E in FIG 2 ersichtlich. Der eigentliche sogenannte Spannungserhöhungstakt an der Eingangsklemme 4 ist in FIG 2 in der Teilfigur B dargestellt. Mit der steigenden Flanke werden nun beide Kondensatoren 10 und 11 einseitig beaufschlagt, da der erste Eingang des UND-Gatters 12 über den Inverter 14 auf logisch 1 geschaltet ist. Dadurch wird über die beiden Kapazitäten 10, 11 die Spannung am Knoten E auf ca. 8 V geschoben. Dies ist z. B. ein Standardspannungswert bei Wortleitungsverstärkern in dynamischen Speichern.

Bei Versorgungsspannungen $V_{CC}$ = V2, die größer der zuvorgenannten Schwelle liegen, liegt am Ausgang des Spannungskomparators ein logisches 1-Signal an. Dadurch wird der FET 7 leitend geschaltet und damit der an der Eingangsklemme 1 anliegende Vorladetakt unterdrückt. Somit wird während der Pause, d. h. während der Zeit, in der an der Eingangsklemme 4 ein logisches 0-Signal anliegt, der Knoten E über den als Diode geschalteten Transistor 9 auf den Wert $V_{CC}$ abzüglich der Durchlaßspannung vorgeladen. Über den Inverter 14 wird nun am ersten Eingang des UND-Gatters 12 ein logisches 0-Signal angelegt, wodurch der Ausgang des UND-Gatters 12 stets auf logisch 0 bleibt. Der Kondensator 10 wird durch diese Maßnahme deaktiviert und spielt bei der nachfolgenden Spannungserhöhung keine Rolle. Mit der in Teilfigur B der FIG 3 dargestellten steigenden Flanke des Spannungserhöhungssignals erhöht sich auch die Ausgangsspannung am Knoten E, diesmal jedoch um einen niedrigeren Wert, da die wirksame Schiebekapazität des Kondensators 11 geringer als im vorher beschriebenen Fall ist.

Normiert man die gesamtwirkende Schiebekapazität auf 1, so wäre eine sinnvolle Verteilung der Kapazitäten im Verhältnis ein Drittel für den Kondensator 10 zu zwei Drittel für den Kondensator 11 eine sinnvolle Ausgestaltung. Die Gesamthöhe des Spannungshubs hängt vom Verhältnis der Lastkapazität, sprich der Kapazität des Knotens E zur Schiebekapazität, d. h. der Kapazität der wirksamen Schiebekondensatoren 10, 11 ab.

Selbstverständlich können mehrere Kondensatoren parallel geschaltet werden. Eine entsprechende Ansteuerungslogik kann dann in üblicher Weise ausgestaltet werden. Je mehr Kapazitäten parallel geschaltet werden, um so spezieller müßten jedoch auch die Ausgestaltung des Spannungskomparators erfolgen. Dieser müßte entsprechende Abstufungen der Versorgungsspannung ähnlich einem AD-Wandler in ein entsprechendes Digitalsignal umwandeln, welches nachfolgend von der Ansteuerlogik ausgewertet wird.

Bei entsprechender Auslegung der Schaltung kann unter Umständen auch der zuschaltbare Schaltungsteil, bestehend aus dem FETs 7, 8, dem Kondensator 6 und der Treiberstufe 5, der zum zusätzlichen Vorladen des Knotens E dient, entfallen.

## Patentansprüche

1. Schaltungsanordnung zur Begrenzung der Ausgangsspannung bei einer Spannungserhöhungsschaltung, die von einer Versorgungsspannungsquelle gespeist wird, wobei die Spannungserhöhungsschaltung erste Mittel (9) enthält, die einen Knoten (E) auf einen ersten Spannungswert nahe der Versorgungsspannung vorladen und zweite Mittel enthält, die den Knoten (E) vom ersten Spannungswert auf einen höheren zweiten Spannungswert schieben,
   **dadurch gekennzeichnet, daß**
   - die zweiten Mittel mindestens zwei Kapazitäten (10, 11) enthalten, die einerseits mit dem Knoten (E) verbunden sind,
   - eine Ansteuerschaltung (12, 13, 14), vorhanden ist, die entsprechend der Anzahl von Kapazitäten Ausgangssignale erzeugt, die den jeweils anderen Anschlüssen der Kapazitäten (10, 11) zugeführt werden,
   - ein Spannungskomparator (15, 16, 17, 18) vorgesehen ist, der ein Ausgangssignal in Abhängigkeit der Höhe der Versorgungsspannung erzeugt, das der Ansteuerschaltung (12, 13, 14) zugeführt wird,
   - in Abhängigkeit des Ausgangssignals des Spannungskomparators (15, 16, 17, 18) eine Anzahl von Kapazitäten (10, 11) ausgewählt wird und durch Zuführen eines rechteckförmigen Signals an die jeweiligen Kapazitäten (10, 11) der Spannungswert am Knoten (E) erhöht wird.

2. Schaltungsanordnung nach Anspruch 1,
   **dadurch gekennzeichnet, daß**
   zuschaltbare dritte Mittel (7, 8) vorgesehen sind, die während einer Vorladephase, den Knoten (E) auf einen vom ersten Spannungswert höheren Wert, der kleiner gleich der Versorgungsspannung ist, aufladen.

3. Schaltungsanordnung nach Anspruch 1,
   **dadurch gekennzeichnet, daß**
   das erste Mittel eine in Flußrichtung zwischen Versorgungsspannung und Knoten geschaltete Diode (9) ist,
   - daß die zweiten Mittel zwei Kapazitäten (10, 11) enthalten,
   - die Ansteuerschaltung eine erste Treiberstufe (13), ein UND-Gatter (12) und einen Inverter (14) aufweist,
   - der Treiberstufe (13) ein Steuersignal über eine Anschlußklemme (4) zugeführt wird,

   - der erste Eingang des UND-Gatters (12) mit der Anschlußklemme (4) verbunden ist, - dem Eingang des Inverters (14) das Ausgangssignal des Spannungskomparators (15, 16, 17, 18) zugeführt wird und der Ausgang des Inverters (14) mit dem zweiten Eingang des UND-Gatters (12) verschaltet ist, wobei der Ausgang der Treiberstufe (13) mit dem anderen Anschluß der ersten Kapazität (11) und der Ausgang des UND-Gatters (12) mit dem anderen Anschluß der zweiten Kapazität (10) verbunden ist.

4. Schaltungsanordnung nach Anspruch 2 in Verbindung mit Anspruch 3,
   **dadurch gekennzeichnet, daß**
   die dritten Mittel einen Transistor (8) aufweisen, dessen Laststrecke parallel zu der der Diode (9) geschaltet ist, daß der Steuereingang des Transistors (8) von einem Vorladetaktsignal angesteuert wird und daß Mittel (7) zum Deaktivieren des Vorladetaktsignales vorgesehen sind, die vom Ausgangssignal des Spannungskomparators (15, 16, 17, 18) gesteuert werden.

5. Schaltungsanordnung nach Anspruch 3 oder 4,
   **dadurch gekennzeichnet, daß**
   - der Spannungskomparator drei Transistoren (15, 16, 18) und einen Widerstand (17) aufweist,
   - die Laststrecke des ersten Transistors (15) und des zweiten Transistors (16) in Reihe zwischen einer Versorgungsspannungsklemme (2) und Masse geschaltet sind,
   - der Steueranschluß des zweiten Transistors (16) mit der Versorgungsspannungsklemme (2) verbunden ist,
   - die Laststrecke des dritten Transistors (18) und der Widerstand (17) in Reihe zwischen der Versorgungsspannungsspannungsklemme (2) und Masse geschaltet ist, wobei der Widerstand (17) masseseitig geschaltet ist,
   - der Steueranschluß des ersten Transistors (15) mit dem Knotenpunkt der Reihenschaltung des dritten Transistors (18) und des Widerstands (17) verbunden ist,
   - der Steueranschluß des dritten Transistors (18) mit Masse verschaltet ist,
   - das Kanalweiten- zu Kanallängenverhältnis des zweiten und dritten Transistors (16, 18) klein ist,
   - am Knotenpunkt der Reihenschaltung der Laststrecken des ersten und zweiten Transistors (15, 16) das Ausgangssignal des Spannungskomparators abgreifbar ist.

6. Schaltungsanordnung nach einem der Ansprüche 3, 4 oder 5,
**dadurch gekennzeichnet,** daß
das Kapazitätsverhältnis der beiden Kapazitäten (10, 11) ein Drittel zu zwei Drittel beträgt.

FIG 1

FIG 2

$U$

$V_{CC} = V_1$

A

B

C

D

E

$t$

FIG 3

$U$

$V_{CC} = V_2$

A

B

C

D

E

$t$

Europäisches
Patentamt

**EUROPÄISCHER RECHERCHENBERICHT**

Nummer der Anmeldung

EP    92 11 2606

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| X | US-A-4 583 157 (KIRSCH ET AL)<br>* Zusammenfassung; Abbildungen 3,4 *<br>* Spalte 3, Zeile 5 - Spalte 4, Zeile 17 *<br>--- | 1 | G11C5/14<br>G11C11/407 |
| Y | US-A-5 073 731 (OH)<br>* Spalte 5, Zeile 59 - Spalte 8, Zeile 2; Abbildungen 3,4,5 *<br>--- | 1-3 | |
| Y<br>A | EP-A-0 109 139 (FUJITSU)<br>* Zusammenfassung; Abbildungen 1,2A *<br>* Seite 3, Zeile 14 - Seite 4, Zeile 30 *<br><br>----- | 1-3<br>4 | |
| | | | **RECHERCHIERTE SACHGEBIETE (Int. Cl.5 )**<br><br>G11C |

Der vorliegende Recherchenbericht wurde für alle Patentansprüche erstellt

| Recherchenort | Abschlußdatum der Recherche | Prüfer |
|---|---|---|
| DEN HAAG | 22 MAERZ 1993 | CARDUS, A. |